# EUROPEAN PATENT APPLICATION

(11) **EP 2 675 054 A1**
(43) Date of publication of application: **18.12.2013**
(21) Application number: 12745379.3
(22) Date of filing: 07.02.2012
(51) Int. Cl.: H02M 7/48, H05K 7/20

(54) **POWER CONDITIONER**

(30) Priority: 08.02.2011 JP 2011025134; 08.02.2011 JP 2011025036; 10.02.2011 JP 2011027270
(71) Applicant: Sanyo Electric Co., Ltd., Osaka 570-8677 (JP)
(72) Inventor: TABATA Tomohiro, Moriguchi-shi, Osaka 570-8677 (JP); MIYAUCHI Taku, Moriguchi-shi, Osaka 570-8677 (JP)
(74) Representative: Glawe, Delfs, Moll
(86) International application number: PCT/JP2012/052662
(87) International publication number: WO 2012/108398

(57) **Abstract**

To provide a technique whereby the heat generated by circuit elements of a power conditioner, particularly by elements that generate large amounts of heat, is satisfactorily released and not confined within a housing when a housing for outdoor installation is endowed with a sealed structure for the purpose of waterproofing, and particularly to provide a novel configuration taking into account the heat generated by a reactor that generates a large amount of heat. [Solution] A power conditioner in which a step-up part for boosting a direct-current voltage generated by a solar cell, an inverter part for converting the direct-current electrical power boosted by the step-up part into alternating-current electrical power, and a filter part for shaping the waveform of the alternating-current electrical power converted by the inverter part are housed in a housing having a sealed structure, wherein: at least a portion of a back wall of the housing comprises a heat sink; a printed wiring board is disposed parallel to a base part of the heat sink, a space being present between the printed wiring board and the heat sink; and a heat-generating element of the step-up part is connected to the printed wiring board on the side of the space and attached in thermally conducting fashion to the base part of the heat sink via a thermal conducting block at a position removed from the printed wiring board.

## Description

### TECHNICAL FIELD

The present invention relates to an inverter, and particularly relates to a cooling technique for heat-generating parts in an inverter for converting direct-current power generated by a solar cell or the like into alternating-current power.

### BACKGROUND ART

In order to obtain good heat release characteristics and ensure that the surface of a housing does not reach high temperatures, a known inverter for an indoor-mounted solar power generation system has a metal housing, a DC-to-AC conversion circuit for converting direct-current power generated by a solar cell to alternating-current power and a heat sink to which a power module for the DC-to-AC conversion circuit is attached are provided within the housing, and an outside resin sheet is affixed to a top surface of a top plate of the metal housing (see Patent Reference 1).

### Prior Art References

### Patent References

[Patent Reference 1]: Japanese Laid-open Patent Application No. 2009-164351

### DISCLOSURE OF THE INVENTION

### [Problems the Invention Is Intended To Solve]

Patent Reference 1 discloses effects whereby heat inside the housing of the inverter can be satisfactorily released, burns and other injuries from touching the housing of the inverter can be prevented, and the inverter is suitable for indoor mounting.

The present invention provides an outdoor-mounted an inverter rather than an indoor-mounted inverter such as described above, and relates to a structure for enhancing the heat release characteristics of electrical components housed inside an inverter in order to obtain an outdoor-mounted configuration.

In an inverter, power obtained by converting direct-current power generated by a solar cell into alternating-current power through a step-up circuit including a diode, a direct-current/alternating-current conversion circuit (referred to as a DC/AC conversion circuit or an inverter circuit), and a filter circuit including a reactor is supplied to a commercial power system GRID, but the circuits of the inverter include electrical components that generate large amounts of heat, such as the direct-current/alternating-current conversion circuit, the reactor of the filter circuit, and the diode of the step-up circuit. When the heat generated by these components is confined in the housing, there is a risk of malfunctioning or variation in the characteristics of the circuit elements.

Various techniques have been proposed whereby the heat generated from a direct-current/alternating-current conversion circuit and a filter circuit reactor is dissipated from a heat sink, but an object of the present invention is particularly to provide a technique whereby the heat generated from the heat-generating electrical components (diodes and the like) of a step-up circuit is not confined in a housing and is satisfactorily released to the outside of the housing via a heat sink.

An object of the present invention is also to provide a technique for suppressing thermal interference in the releasing of heat from each component on a heat sink, and ensuring that heat is satisfactorily released to the outside of the housing when heat-generating electrical components of a step-up circuit, in addition to a direct-current/alternating-current conversion circuit and a reactor, are attached to a single heat sink.

### [Means for Solving the Abovementioned Problems]

The inverter of the present invention is an inverter in which a step-up part for boosting the voltage of a direct-current power generated by a solar cell or the like, a DC/AC conversion circuit for converting the direct-current power boosted by the step-up part into alternating-current power, and a filter part for shaping the waveform of the alternating-current power converted by the DC/AC conversion circuit are housed in a single housing; wherein the inverter is characterized in that: the housing has a sealing structure for waterproofing; at least a portion of a back panel of the housing comprises a heat sink; a printed circuit board is disposed substantially parallel to a base part of the heat sink, a space being present between the printed circuit board and the heat sink; a heat-generating electrical component constituting the step-up part is connected to the printed circuit board and attached in thermally conducting fashion to the base part of the heat sink via a thermal conducting member at a position removed from the printed circuit board and near an external periphery thereof; and a switching element constituting the DC/AC conversion circuit is connected to the printed circuit board and attached in thermally conducting fashion to the base part of the heat sink at a position not removed from the printed circuit board .

Through this configuration, a heat-generating electrical component constituting the step-up part is connected to the printed circuit board and attached in thermally conducting fashion to the base part of the heat sink via a thermal conducting block at a position removed from the printed circuit board and near an external periphery thereof. Therefore, in the relationship to the arrangement of the printed circuit board disposed in the housing, effects are obtained whereby heat generated from the heat-generating electrical component that constitutes the step-up part is not confined in the housing, and is satisfactorily released to the outside of the housing. Since this heat-generating electrical component is also attached to the heat conducting member at a position removed from the printed circuit board, connection to the printed circuit board can be achieved without making the connection terminals particularly long, the electrical component can be attached to the thermal conducting member after the connected printed circuit board is attached, and attachment to the thermal conducting member is also facilitated. Since the switching element which constitutes the DC/AC conversion circuit connected to the printed circuit board is also attached in thermally conducting fashion to the base part of the heat sink at a position not removed from the printed circuit board , the switching element can be disposed on the heat-sink-base-part side of the printed circuit board , and a good heat releasing arrangement can be achieved which makes effective use of the space between the printed circuit board and the base part of the heat sink.

The invention described above is also characterized in that inside the housing, a reactor constituting the filter part is housed in a top-part side, other circuit elements including the printed circuit board are housed in underside, and a passage for ascension of air is configured in the space between the printed circuit board and the base part of the heat sink.

The invention described above is also characterized in that the heat sink is made of aluminum, the thermal conducting member is made of aluminum as a block shape attached to the base part of the heat sink, and the heat-generating electrical component is fixed to a front-surface side of the heat conducting member using a fastener.

The invention described above is also characterized in that the external periphery of a coil of the reactor provided to the filter part is attached in thermally conducting fashion to the base part of the heat sink via a flexible thermal conducting sheet and electrically insulating sheet.

The invention described above is also characterized in that the external periphery of the reactor provided to the step-up part is attached in thermally conducting fashion to the base part of the heat sink via a flexible thermal conducting sheet and electrically insulating sheet.

The invention described above is also characterized in that the inside of the housing is partitioned by a partition wall so that a chamber housing a reactor provided to the filter part and a reactor provided to the step-up part is an upper chamber, and a chamber housing other circuit elements including the printed circuit board is a lower chamber, the partition wall suppressing air convection between both the chambers, and the heat-generating electrical component is disposed adjacent to the partition wall and in the vicinity of the reactors.

The invention described above is also characterized in that the inside of the housing is partitioned by a partition wall so that a chamber housing the reactors is an upper chamber, and a chamber housing other circuit elements including the printed circuit board is a lower chamber, the partition wall suppressing air convection between both the chambers, and the heat-generating electrical component is disposed adjacent to the partition wall and in the vicinity of the reactors.

The invention described above is also characterized in that the thermal conducting sheet is flexible and has a thickness such that an external periphery of a coil of the reactor makes contact with the thermal conducting sheet so as to dig into a surface thereof, and the electrically insulating sheet holds a back surface of the thermal conducting sheet and has a thickness such that heat generated by the reactors is satisfactorily transmitted to the heat sink.

The invention described above is also characterized in that the housing is sealed up from water , in which an opening on a front side of a casing, which is open on the front side thereof, a periphery of which being enclosed by metal plates, and at least a portion of a back panel thereof comprising a heat sink, is closed by an openable and closable lid, the heat sink side is an attachment side in a state in which the opening is on the front side and a chamber housing the reactors is in a top position, an intelligent power module (IPM) in which a plurality of switching elements are electrically connected in a bridge shape so as to constitute the DC/AC conversion circuit is disposed in the chamber housing the other circuit elements, and a heat-releasing surface of the intelligent power module (IPM) is attached in thermal conducting fashion to the heat sink exposed to the inside of the housing.

The invention described above is also characterized in that in the housing, a heat release promoting fan is provided on the back side of the heat sink, and the cooling fan is disposed in a position corresponding to that of the intelligent power module (IPM).

The invention described above is also characterized in that: the housing is provided with a casing opened on a front side thereof and having the back panel, a lid detachably fixed to the casing so as to open and close the front side opening of the casing, and a gasket attached to a back side of the lid and closely fitted in a state where a front end of a peripheral wall of the front side opening of the casing digs into the gasket; a switch for opening and closing a predetermined circuit part of the inverter is provided inside the casing; a switch operating part for manual operation of the switch is provided in a downward protruding state in a bottom wall of the peripheral wall of the casing; and a lid opening/closing restricting part is provided whereby removal of the lid from the casing is inhibited when the switch operating part is in an ON state of closing a switch circuit, and the inhibiting is removed when the switch operating part is in an OFF state of opening the switch circuit.

The invention described above is also characterized in that the switch operating part is a rotary-type switch operating part which rotates from the OFF state of opening the switch circuit to the ON state of closing the switch circuit, and returns from the ON state of the switch to the OFF state of the switch by rotating in the opposite direction from the rotation, and the lid opening/closing restricting part is provided with a structure in which a fixed-side retaining part, on which a rotating retaining part is retained or released, is provided on a back side of the lid, the rotating retaining part rotating in conjunction with rotation of the switch operating part, and the rotating retaining part is retained on the fixed-side retaining part and removal of the lid is inhibited when the switch is ON, and the inhibition is removed when the switch is OFF.

### [Effect of the Invention]

The present invention makes it possible to provide an inverter in which the heat generated from heat-generating electrical components is not confined in the housing and is satisfactorily released to the outside of the housing via a heat sink.

### BRIEF DESCRIPTION OF THE DRAWINGS

FIG. 1 is a view showing the configuration of the circuit for converting direct current to alternating current in the inverter according to the present embodiment;
FIG. 2 is a view showing the relationship in which the IPM and the heat sink are attached according to the present embodiment;
FIG. 3 is a sectional view showing the relationship in which the IPM and the heat sink are attached according to the present embodiment;
FIG. 4 is a front perspective view showing the inverter according to the present embodiment;

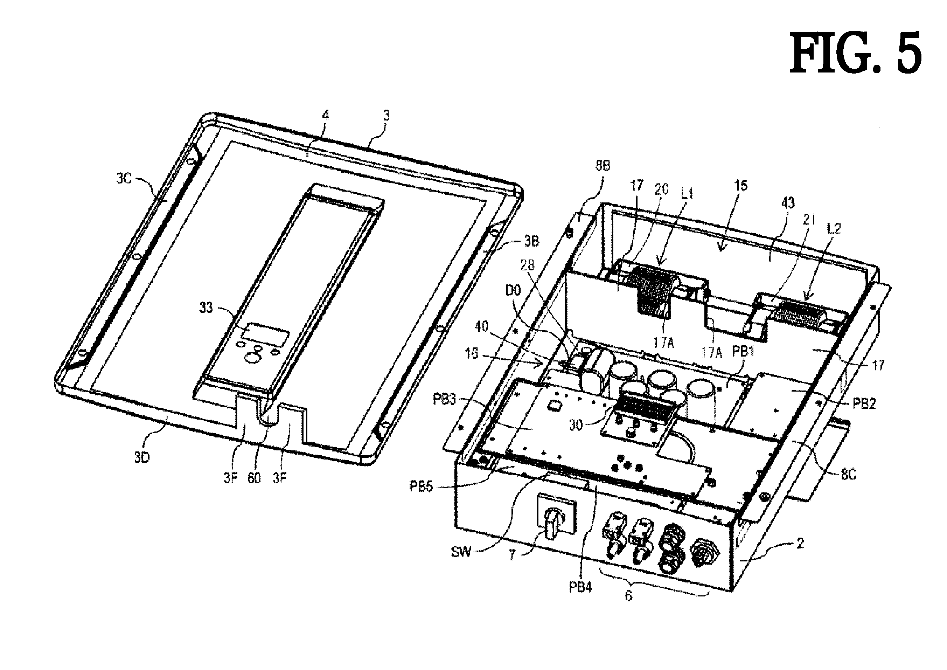

FIG. 5 is a perspective view showing the arrangement of components inside the housing and the back side of the lid in a state in which the lid of the inverter according to the present embodiment is open;
FIG. 6 is a front view showing the arrangement of components inside the housing in a state in which the lid of the inverter according to the present embodiment is open;
FIG. 7 is a longitudinal sectional side view showing the arrangement of components inside the housing of the inverter according to the present embodiment;
FIG. 8 is a perspective view inside the housing in a state in which the lid of the inverter according to the present embodiment is open;
FIG. 9 is a transverse sectional perspective view showing the state in which the reactors inside the housing are attached, in a state in which the lid of the inverter according to the present embodiment is open;
FIG. 10 is a longitudinal sectional side view showing the state in which the diode is attached in the inverter according to the present embodiment;
FIG. 11 is a perspective view showing the diode of the inverter according to the present embodiment;
FIG. 12 is an exploded perspective view showing the configuration of the housing of the inverter according to the present embodiment;
FIG. 13 is a transverse sectional end view showing the relationship of the IPM and the heat release promoting fan inside the housing in a state in which the lid of the inverter according to the present embodiment is open;
FIG. 14 is a perspective view of the inside of the housing, showing an exploded view of the attachment portions of the reactors of the inverter according to the present embodiment;
FIG. 15 is a detailed view showing the attachment portions of the reactors of the filter part, and the attachment/detachment of the lid of the inverter according to the present embodiment;
FIG. 16 is a detailed view showing the attachment portions of the reactors of the filter part, and a state in which the lid of the inverter according to the present embodiment is closed;
FIG. 17 is a detailed view showing the attachment portions of the reactors of the step-up part, and a state in which the lid of the inverter according to the present embodiment is closed;
FIG. 18 is a perspective view showing the switch OFF state in which the switch operating part allows removal of the lid in the inverter according to the present embodiment;
FIG. 19 is a view showing the switch ON state in which the switch operating part inhibits removal of the lid in the inverter according to the present embodiment;
FIG. 20 is a view showing the switch OFF state in which the switch operating part no longer inhibits removal of the lid in the inverter according to the present embodiment;
FIG. 21 is a view showing another configuration, showing the switch ON state (solid lines) in which the switch operating part inhibits removal of the lid, and the switch OFF state (dashed lines) in which the inhibition is removed in the inverter according to the present embodiment; and
FIG. 22 is a sectional view showing the switch ON state in which the switch operating part in FIG. 21 inhibits removal of the lid.

### BEST MODE FOR CARRYING OUT THE INVENTION

The present embodiment is of an inverter in which a step-up part for boosting the voltage of a direct-current power generated by a solar cell or the like, a DC/AC conversion circuit for converting the direct-current power boosted by the step-up part into alternating-current power, and a filter part for shaping the waveform of the alternating-current power converted by the DC/AC conversion circuit are housed in a single housing; wherein the power converter is configured such that: the housing has a sealing structure for waterproofing; at least a portion of a back panel of the housing comprises a heat sink; a printed circuit board is disposed substantially parallel to a base part of the heat sink, a space being present between the printed circuit board and the heat sink; a heat-generating electrical component constituting the step-up part is connected to the printed circuit board and attached in thermally conducting fashion to the base part of the heat sink via a thermal conducting member at a position removed from the printed circuit board and near an external periphery thereof; and a switching element constituting the DC/AC conversion circuit is connected to the printed circuit board and attached in thermally conducting fashion to the base part of the heat sink at a position not removed from the printed circuit board. This embodiment is described below with reference to the accompanying drawings.

### Embodiment 1

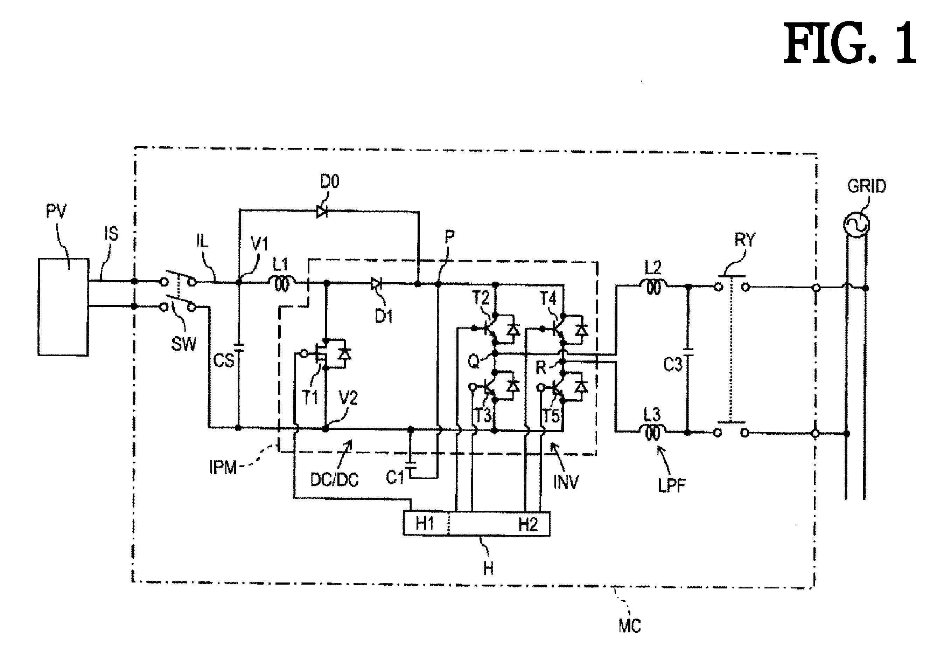

The inverter PCD according to the present embodiment is configured such that an electric circuit part CT including high-voltage electrical components and performing an intended operation is housed in a housing 1. FIG. 1 shows the configuration of a main circuit MC in this electric circuit part CT of the inverter PCD according to the present embodiment. As shown in FIG. 1, a step-up part DC/DC is provided which constitutes a step-up circuit for boosting the direct-current voltage of a direct-current power generated by a solar cell PV, and a DC/AC conversion circuit INV is provided which constitutes an inverter circuit for converting the direct-current power boosted by the step-up part DC/DC into alternating-current power. In this configuration, after the direct-current power from the solar cell PV, which is a direct-current power source, is boosted in the step-up part DC/DC by a chopper operation, and the direct-current power boosted by the step-up part DC/DC is converted (DC/AC conversion) to alternating-current power by the DC/AC conversion circuit INV, the alternating-current power is supplied to a single-phase alternating-current 200 V commercial power system GRID as sinusoidal alternating-current power having a predetermined low frequency that corresponds to the frequency of the commercial power system GRID, via a filter part LPF which constitutes a low-pass filter circuit. The step-up part, the DC/AC conversion circuit, and other components are high-voltage electrical components.

As shown in FIG. 1, in the step-up part DC/DC, a step-up circuit is constituted by a reactor L1, a switching element T1, a diode D0, a diode D1, and a capacitor C1, and the direct-current voltage supplied from the solar cell PV is boosted to a predetermined voltage by the turning ON (on) and OFF (off) of the switching element T1 by control performed by a chopper control part H1.

In the DC/AC conversion circuit INV, four switching elements T2 through T5 are single-phase full-bridge connected for switching control, the four switching elements T2 through T5 are turned ON (on) and OFF (off) by a PWM control part H2, and the direct-current power supplied from the step-up part DC/DC is converted to alternating-current power having a predetermined frequency that corresponds to the frequency of the commercial power system GRID. The DC/AC conversion circuit INV can therefore be referred to as a DC/AC converter.

In the filter part LPF, a low-pass filter circuit for intercepting high frequencies is constituted by a reactor L2, a reactor L3, and a capacitor C3, the junction point Q of the switching elements T2 and T3 of the DC/AC conversion circuit INV is connected to the reactor L2, the junction point R of the switching elements T4 and T5 is connected to the reactor L3, and a pulsed voltage outputted from the DC/AC conversion circuit INV is smoothed (high-frequency components are removed) to obtain a sinusoidal alternating-current voltage having a frequency that corresponds to the frequency of the commercial power system GRID, and outputted to the commercial power system GRID via a control relay RY.

In the step-up part DC/DC as shown in FIG. 1, when the switching element T1 is in the on state (turned ON), energy is accumulated in the reactor L1, and when the switching element T1 is in the off state (turned OFF), the energy accumulated in the reactor L1 is released, and charges the capacitor C1. In this case, by control of the ratio of ON time and OFF time of the switching element T1, the step-up part DC/DC boosts the voltage of the direct-current power supplied from the solar cell PV to a predetermined voltage. The purpose of the diode D1 is to prevent electric current from flowing back toward the solar cell PV, and a diode in parallel with the switching element T1 serves to protect the switching element T1.

The diode DO is connected so as to bypass the reactor L1 and the diode D1, and when the voltage generated by the solar cell PV exceeds the terminal voltage (voltage at position P) of the capacitor C1, the output of the solar cell PV directly charges the capacitor C1 via the diode D0, and is supplied to the DC/AC conversion circuit INV. Specifically, when a large amount of power is generated by the solar cell PV and there is no need for boosting by the step-up part DC/DC, the output of the solar cell PV is supplied to the DC/AC conversion circuit INV without passing through the reactor L1 and the diode D1, loss of generated electrical power by at least the reactor L1 can be prevented, and the efficiency of conversion in the inverter can be increased. However, since the output of the solar cell PV continuously passes through, a large amount of heat is generated. This amount of generated heat is large relative to a state in which the diode D1 is intermittently energized by the operation of the switching element T1.

In such operation, in order to cause the output of the step-up part DC/DC to reach the maximum value (PW) thereof, the chopper control part H1 operates to perform control for causing the step-up part DC/DC to operate at the maximum output electrical power of the solar cell PV. As one control scheme for this purpose, the voltage and current outputted from the step-up part DC/DC are detected, and the step-up ratio of the step-up part DC/DC is controlled so that the product (output electrical power) of the detected voltage and current is maximized. For example, the current IS of the solar cell PV, the voltage VCS of a capacitor CS connected in parallel to the solar cell PV, and the current IL of the reactor L1 are detected by the chopper control part H1, switching of the switching element T1 is thereby controlled, and the step-up ratio (ON duty of the switching element T1) of the step-up part DC/DC can be controlled so that the electrical power outputted from the step-up part DC/DC is maximized.

In the DC/AC conversion circuit INV, the peak value of the sinusoidal alternating-current voltage superposed on the commercial power system GRID is controlled by the PWM control part H2 so that the current calculated on the basis of the maximum value (PW) is outputted to the commercial power system GRID.

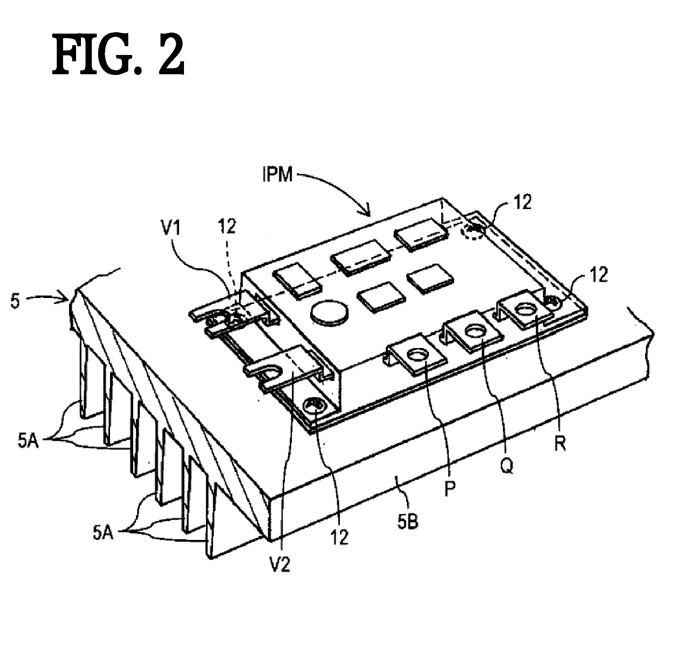

As shown in FIG. 1, a main control part H of the main circuit MC of the inverter PCD includes the chopper control part H1 and the PWM control part H2. The portion of the main circuit MC of the inverter PCD surrounded by a dashed line in FIG. 1 is wired on a single printed circuit board PB1, and each of the switching elements T1 through T5 is commonly referred to as an insulated gate bipolar transistor (IGBT). As shown in FIG. 2, the switching elements T2 through T5 are modularized so as to be housed in a single (one) package, referred to as an intelligent power module (IPM). In order to obtain an advantage in manufacturing, the switching element T1 and the diode D1 may also be modularized so as to be housed in a single (one) package together with the switching elements T2 through T5. FIG. 2 therefore shows an IPM module in which the switching elements T1 through T5 and the diode D1 are housed in a single (one) package.

In this IPM, V1 and V2 correspond to V1 and V2 shown in FIG. 1, and P, Q, and R correspond to P, Q, and R shown in FIG. 1. Circuit elements that generate a large amount of heat include the switching elements T2 through T5 of the DC/AC conversion circuit INV, and, as described hereinafter, the IPM in which the switching elements T2 through T5 are housed is configured such that a back surface (underside or bottom surface in FIG. 2) thereof is a heat-releasing surface KH made of aluminum or other metal, attachment flanges of the IPM are fixed to a heat sink 5 by screws 12 so that the heat-releasing surface KH is closely fitted to a front surface of the heat sink 5 described hereinafter, and heat generated by the IPM is dissipated by the heat sink 5.

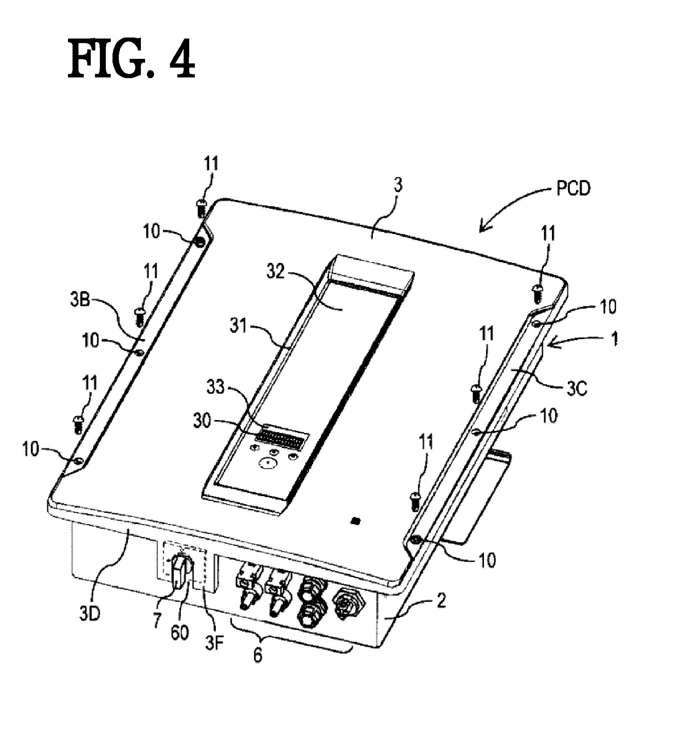

FIG. 4 is an overall perspective view showing the inverter PCD according to the present embodiment, housed in a housing having a sealing structure for waterproofing. The inverter PCD is mounted outdoors in a longitudinal direction, e.g., attached in a substantially vertical state to an outer upright wall HK of a dwelling. A configuration is therefore adopted in which the electric circuit portions including the main circuit shown in FIG. 1 are housed in a waterproof-structured housing 1 for protecting against raindrops and the like.

The housing 1 is a substantially rectangular metal box closed by a metal casing 2 and a metal lid 3 whereby an opening 1A at the front of the casing 2 can be opened and closed, at least a portion of a back panel of the housing 1 comprises the heat sink 5, and the electric circuit part of the inverter PCD is housed inside the housing 1. In the heat sink 5, a plurality of longitudinally directed heat releasing fins 5A are formed and arranged with vertically directed air passages 5C therebetween on the back side of a flat plate-shaped base part 5B, and the heat sink 5 is mass-produced by extrusion molding aluminum or another good thermal conductor into an elongated product and cutting the product to a predetermined length. The heat sink 5 is attached to the casing 2 in a state in which the base part 5B faces into the housing 1 and the heat releasing fins 5A are exposed on the back side of the housing 1. Since the housing 1 is to be mounted outdoors, the housing 1 is made of metal for the sake of light resistance so as not to be degraded by sunlight.

In the casing 2 made of metal, a peripheral wall 2S is formed by top and bottom walls 2A, 2B and left and right walls 2C, 2D, and openings 2F, 2R are formed on the front side and the back side. The base part 5B of the heat sink 5 is attached by screws 9 to flanges 2R1 on a rim of a back opening 2R so as to be closely fitted to the flanges 2R1, and the back opening 2R of the casing 2 is blocked in a waterproof state, so that the heat sink 5 constitutes at least a portion of the back panel 2E of the casing 2. This assembly causes the heat releasing fins 5A to be exposed on the back side of the housing 1. In this case, a sealing gasket may be interposed between the flanges 2R1 and the heat sink 5.

The front opening 2F of the casing 2 is also closed in a waterproof state by the openable and closable lid 3. An annular waterproofing gasket 4 is attached by double-sided tape or the like to an inside rim of the lid 3. Attachment parts 3B, 3C formed at left and right edges of the lid 3 are fixed to attachment flanges 8B, 8C provided on the left and right walls 2C, 2D of the peripheral wall 2S of the casing 2 by screws 11 through attachment holes 10 which pass through the attachment parts 3B, 3C. By this fixing, the distal end (front end) of the peripheral wall 2S forming the front opening 2F of the casing 2 makes contact with the gasket 4 so as to dig into the gasket 4, and the casing 2 and the lid 3 are thereby sealed in a waterproof state. The lid 3 can be removed from the casing 2 by loosening the screws 11.

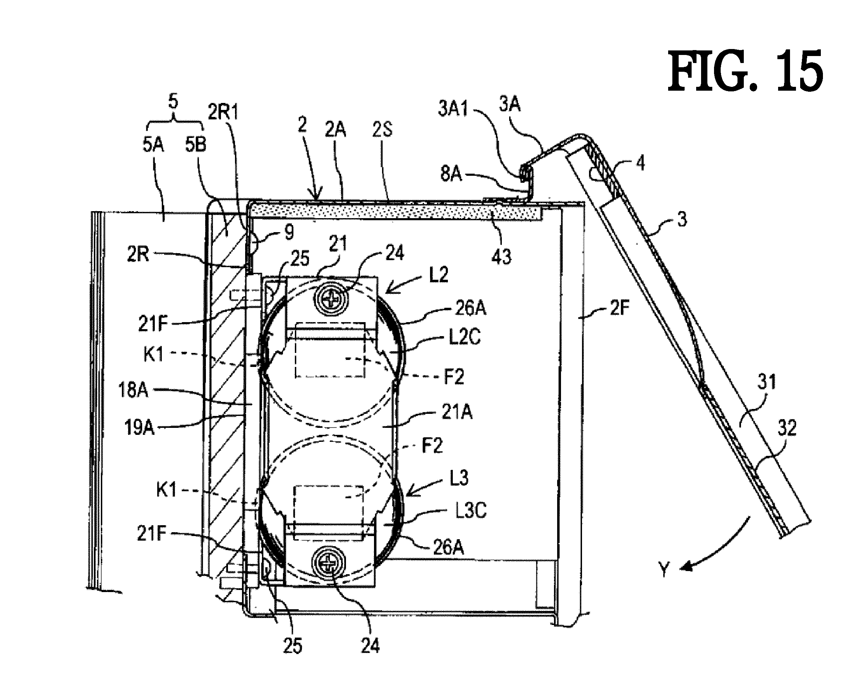

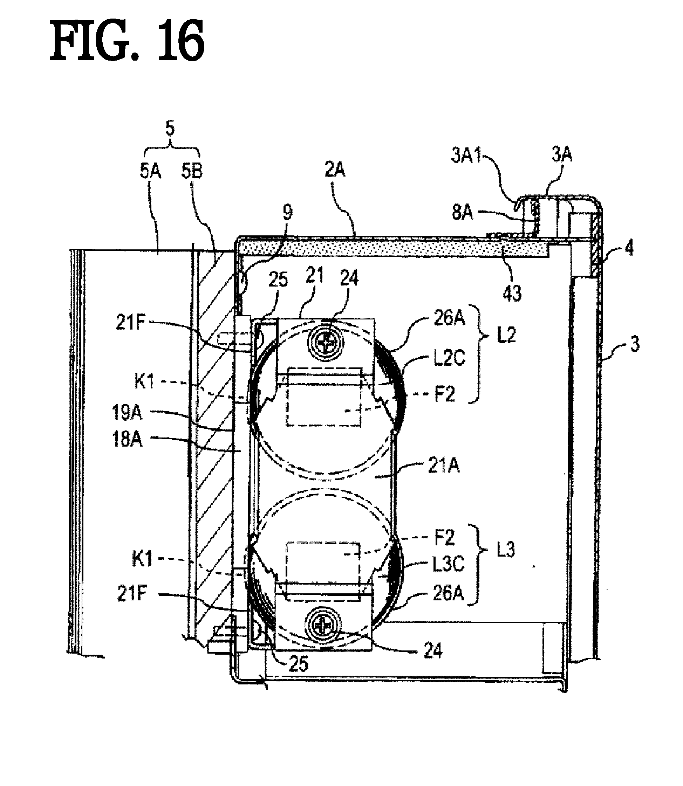

An upwardly protruding retaining flange 8A is provided to the top wall 2A of the peripheral wall 2S of the casing 2, and the lid 3 is attached to the casing 2 by a process in which a retaining part 3A1 formed facing downward on a top edge 3A of the lid 3 is manipulated so as to be retained by the retaining flange 8A of the top wall 2A of the casing 2, as shown in FIG. 15, in a state in which a bottom part of the lid 3 is lifted up at an angle with respect to the casing 2 attached substantially vertically to the outer upright wall HK of a dwelling, the front opening 1A of the casing 2 is closed by the rotation of the lid 3 while the bottom part of the lid 3 is brought toward the casing 2 in the direction of the arrow Y from the locked state, and the lid 3 having sufficient size to cover the entire front opening 1A is fixed by the screws 11 to the attachment flanges 8B, 8C provided to the left and right walls 2C, 2D of the peripheral wall 2S of the casing 2 as described above. By this fixing, the distal end (front end) of the peripheral wall 2S forming the rim of the front opening 1A is closely fitted in a state of digging into the waterproofing gasket 4 attached to the inside rim of the lid 3, as shown in FIG. 16, and a waterproof seal is established along the entire periphery of the front opening 1A.

As for removing the lid 3, the lid 3 can be removed from the casing 2 by loosening the screws 11, lifting up the lid 3 to a position where the retaining part 3A1 of the top edge 3A of the lid 3 separates from the retaining flange 8A in a state in which the bottom part of the lid 3 is lifted up at an angle with respect to the casing 2, as shown in FIG. 15, and pulling the lid 3 forward in this state.

Lead wire lead-outs 6 and a switch operating part 7 for manual operation are provided in the bottom wall 2B of the peripheral wall 2S of the casing 2 so as to protrude downward from the bottom wall 2B. The lead wire lead-outs 6 are portions through which are passed a connection line for connecting the solar cell PV and the electric circuit part CT housed in the housing 1, a connection line for connecting to the commercial power system GRID via the filter part LPF or the control relay RY, or other lead wires. The switch operating part 7 is a portion for manually performing ON/OFF control of a switch SW disposed in the housing 1 from outside the housing 1. The switch SW is a switch for opening and closing a predetermined circuit part of the inverter PCD, and in the present embodiment, the switch SW is interposed in a lead wire for connecting the generated output from the solar cell PV to a predetermined circuit part of the inverter PCD, and an opening and closing armature thereof directly opens and closes a circuit to switch the lead wire to the ON state or the OFF state. The switch SW is disposed inside the casing 2 adjacent to the bottom wall 2B of the peripheral wall 2S of the casing 2, and the switch operating part 7 is attached to an operating shaft 7J that passes through the bottom wall 2B from the switch SW and extends to the outside of the housing 1. The lead wire lead-outs 6 and the switch operating part 7 are attached to the bottom wall 2B of the casing 2 by a structure having an appropriate waterproof seal configuration. The lead wire lead-outs 6 and the switch operating part 7 are provided in the bottom wall 2B because this area is not easily reached by raindrops.

In order to enhance safety in the present embodiment, a lid opening/closing restricting part is provided whereby removal of the lid 3 from the casing 2 is inhibited when the switch operating part 7 is switched ON, and removal of the lid 3 is no longer inhibited when the switch operating part 7 is switched OFF. This configuration is described below.

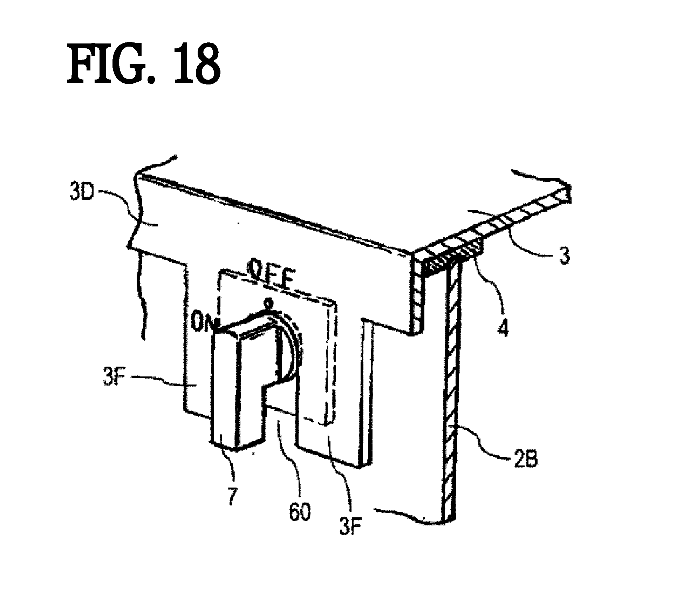

A configuration is described in which this lid opening/closing restricting part is provided. As shown in FIGS. 18 through 20, the switch operating part 7 is a rotary-type switch operating part which rotates from the OFF state of the switch SW to the ON state of the switch SW, and returns from the ON state of the switch SW to the OFF state of the switch SW by rotating in the opposite direction from the above rotation. As shown in FIGS. 18 through 20, a flange 3F is formed extending to the rear at a portion of the bottom edge part of the lid 3, and a hole or a notch 60 from which the switch operating part 7 can escape when the switch SW is OFF is formed in the flange 3F. FIGS. 18 through 20 show a configuration in which the notch 60 is shaped similarly to the switch operating part 7 so that the switch operating part 7 can escape when the switch SW is OFF, but a notch 60 or a hole 60 may be provided whereby the switch operating part 7 can escape when the switch SW is OFF and the switch operating part 7 cannot escape when the switch is ON.

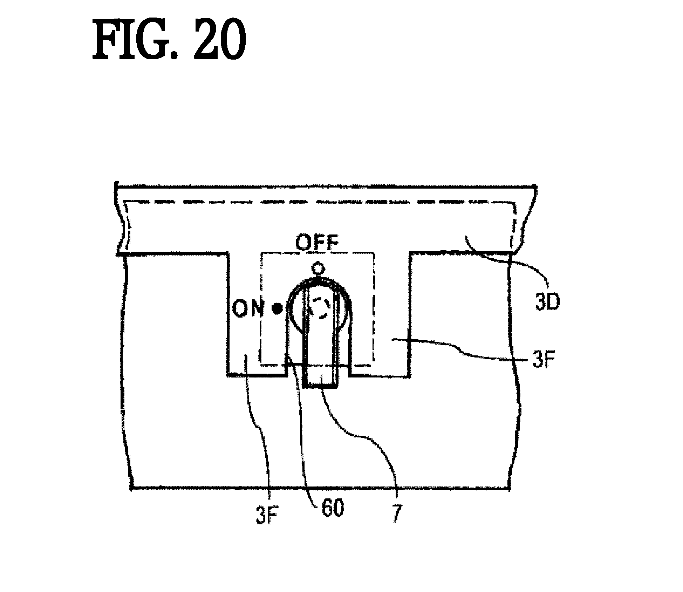

In the OFF state of the switch SW shown in FIGS. 18 and 20, by loosening and removing the screws 11 and pulling the bottom part of the lid 3 forward so as to rotate the lid 3 using the engagement point between the retaining part 3A1 of the top edge 3A of the lid 3 and the retaining flange 8A of the top wall 2A of the casing 2 as an axis as shown in FIG. 15, the lid 3 is inclined, and in conjunction with this rotation, the switch operating part 7 escapes from the hole or the notch 60. The lid 3 is thus not inhibited from rotating by the switch operating part 7, and the lid 3 is smoothly placed in an inclined state as shown in FIG. 15, and in this state, the lid 3 can be removed from the casing 2 by lifting the lid 3 upward to the position where the retaining part 3A1 of the top edge 3A of the lid 3 separates from the retaining flange 8A and pulling the lid 3 forward in this state.

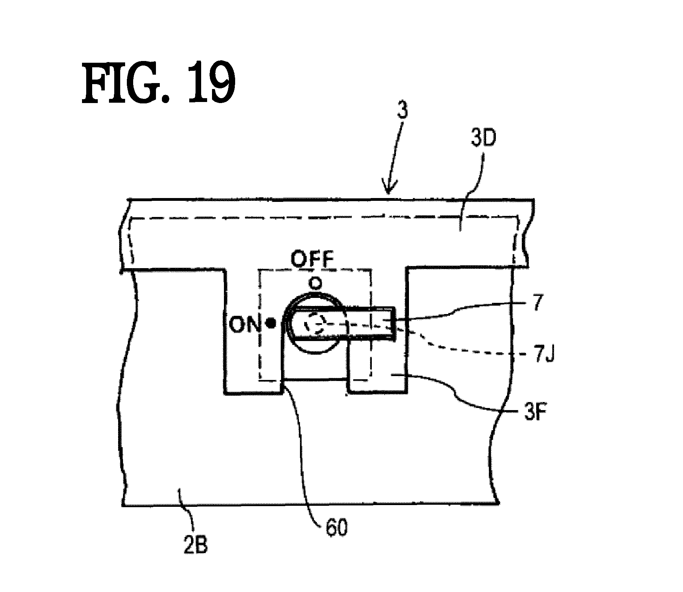

The state shown in FIG. 20 is that of the switch operating part 7 when the switch SW is OFF, but the switch SW is turned ON by rotating the switch operating part 7 substantially 90 degrees counterclockwise, as shown in FIG. 19. In this ON state of the switch SW, the switch operating part 7 no longer corresponds to the hole or notch 60, and is positioned so as to overhang on the flange 3F. In this state, when the screws 11 are loosened and removed, and the bottom part of the lid 3 is pulled forward in rotation using the engagement point between the retaining part 3A1 of the top edge 3A of the lid 3 and the retaining flange 8A of the top wall 2A of the casing 2 as an axis as described above, since the flange 3F at the rim of the hole or notch 60 comes in contact with the back side of the switch operating part 7, the lid 3 is inhibited from rotating further, and the lid 3 cannot be removed. Since the lid 3 thus cannot be removed from the casing 2 when the switch SW is ON even when the screws 11 are loosened and removed, it is not possible to touch the electric circuit parts of the inverter PCD inside the casing 2, and safety is maintained.

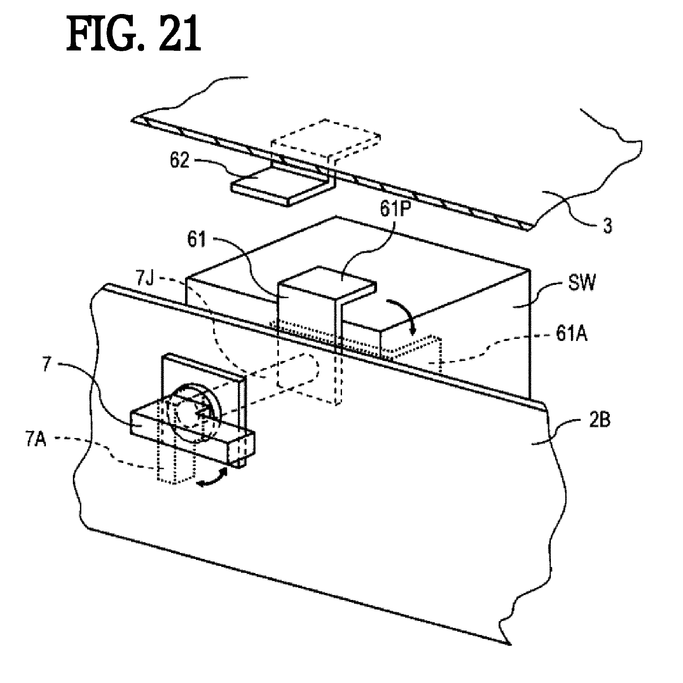

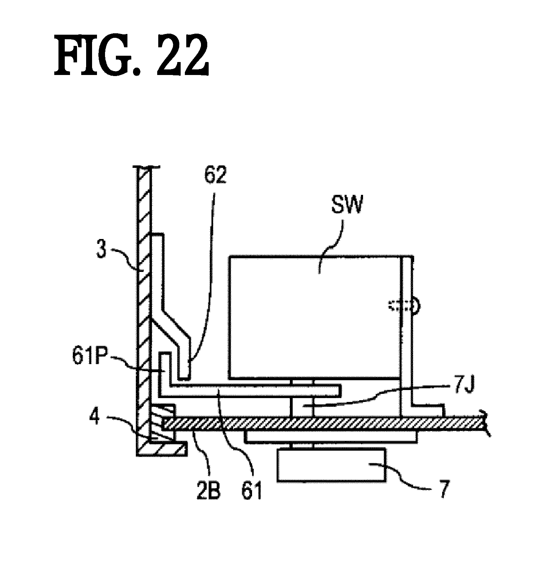

FIGS. 21 and 22 show another configuration of the lid opening/closing restricting part. In this configuration, a rotating retaining part 61, the distal end of which is bent into a hook part 61P, is fixed to a housing 1 inside portion of the operating shaft 7J that extends through the bottom wall 2B from the switch SW to the outside of the housing 1. Meanwhile, a fixed-side retaining part 62 is fixed to the back side of the lid 3 in corresponding fashion to the rotating retaining part 61. In this configuration, when the switch operating part 7 is in the OFF state of the switch SW as indicated by dashed lines 7A in FIG. 21, the rotating retaining part 61 is in a retention-released state as indicated by dashed lines 61A, and the rotating retaining part 61 is separated from the fixed-side retaining part 62 on the back side of the lid 3. Therefore, by loosening and removing the screws 11 and pulling the bottom part of the lid 3 forward so as to rotate the lid 3 using the engagement point between the retaining part 3A1 of the top edge 3A of the lid 3 and the retaining flange 8A of the top wall 2A of the casing 2 as an axis as shown in FIG. 15, the lid 3 is inclined, and the lid 3 is smoothly placed in an inclined state as shown in FIG. 15, and in this state, the lid 3 can be removed from the casing 2 by lifting the lid 3 upward to the position where the retaining part 3A1 of the top edge 3A of the lid 3 separates from the retaining flange 8A and pulling the lid 3 forward in this state.

The switch SW is turned ON by rotating the switch operating part 7 substantially 90 degrees counterclockwise as indicated by solid lines in FIG. 21. In this ON state of the switch SW, the rotating retaining part 61 is placed in an upright retaining state as indicated by solid lines, and in this state, the hook part 61P of the rotating retaining part 61 is retained on the fixed-side retaining part 62 on the back side of the lid 3, as shown in FIG. 22. In this state, when the screws 11 are loosened and removed, and the bottom part of the lid 3 is pulled forward in rotation using the engagement point between the retaining part 3A1 of the top edge 3A of the lid 3 and the retaining flange 8A of the top wall 2A of the casing 2 as an axis as described above, the hook part 61P of the rotating retaining part 61 is retained on the fixed-side retaining part 62 on the back side of the lid 3, the lid 3 is inhibited from rotating further, and the lid 3 cannot be removed. Since the lid 3 thus cannot be removed from the casing 2 when the switch SW is ON even when the screws 11 are loosened and removed, it is not possible to touch the electric circuit parts of the inverter PCD inside the casing 2; the step-up part, DC/AC conversion circuit, and other high-voltage electrical components are not touched, and safety is maintained.

Regardless of the configuration described above, by other configurations of the lid opening/closing restricting part, removal of the lid 3 from the casing 2 is inhibited when the switch operating part 7 is in the ON state of the switch SW, and removal of the lid 3 from the casing 2 is no longer inhibited when the switch operating part 7 is in the OFF state of the switch SW. The lid therefore cannot be opened when the inverter is operating, high-voltage parts are prevented from being touched, and safety is improved.

Following is a description of a technique for dissipating the heat generated by the DC/AC conversion circuit INV, the reactor L1 provided to the step-up part DC/DC, and the reactors L2, L3 provided to the filter part LPF, which are elements that generate large quantities of heat.

The electric circuit part of the inverter PCD housed in the housing 1, including the wiring of the main circuit MC, is formed on a plurality of printed circuit boards PB1 through PB5, and the arrangement of components housed in the housing 1 is partitioned by a partition wall 17 into a first chamber 15 in which the reactors L1, L2, and L3, which are circuit elements that generate large quantities of heat, are disposed, and a second chamber 16 in which the printed circuit boards PB1 through PB5 and other electric circuit portions formed thereon are disposed. The step-up part DC/DC, the DC/AC conversion circuit INV, and the filter part LPF are formed on the printed circuit board PB1, to which the constituent electric elements thereof are connected. The printed circuit boards PB1 through PB5 are disposed parallel to the front surface side of the flat plate-shaped base part 5B of the heat sink 5, a space being provided between the printed circuit boards PB1 through PB5 and the base part 5B.

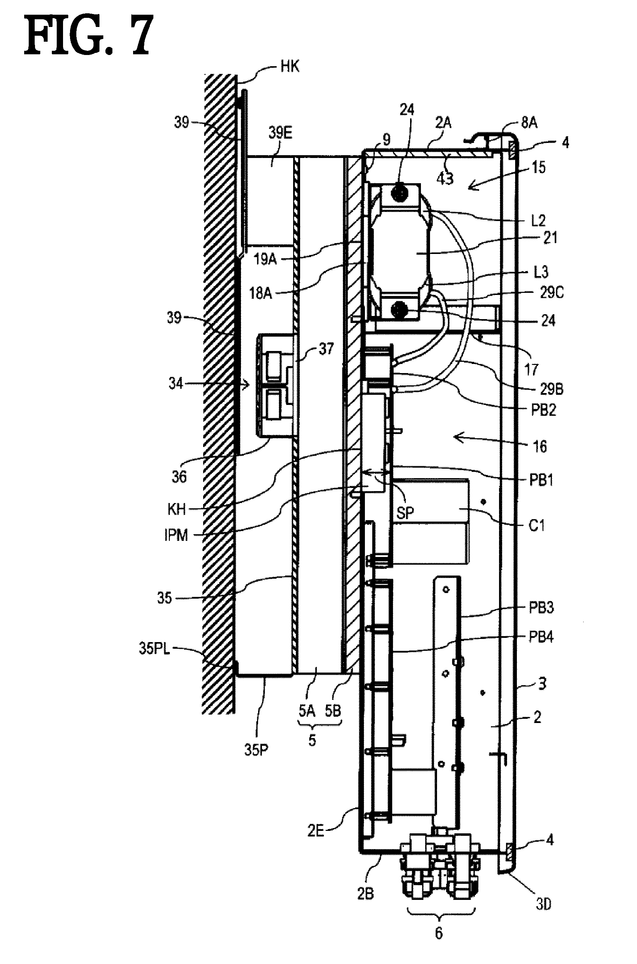

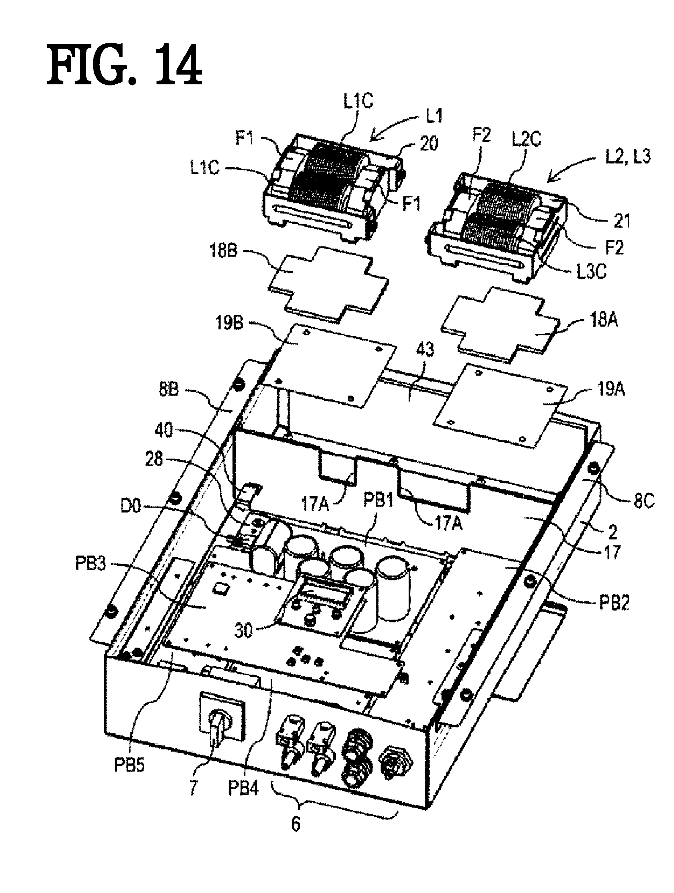

As shown in FIGS. 7, 9, and 14 through 17, the reactors L2, L3 are configured such that external peripheral parts of coil parts constituting the reactors are attached in thermally conducting fashion to the base part 5B of the heat sink 5, the external periphery of which is exposed to the inside of the housing 1, via a flexible thermal conducting sheet 18A and electrically insulating sheet 19A. The thermal conducting sheet 18A is configured from a silicone polymer material impregnated with silicone oil, and the thickness thereof is substantially 3 mm to 10 mm (e.g. 5 mm). The electrically insulating sheet 19A is a synthetic resin sheet, and is a thin sheet 0.5 mm to 2 mm thick so as not to impede the conduction of heat.

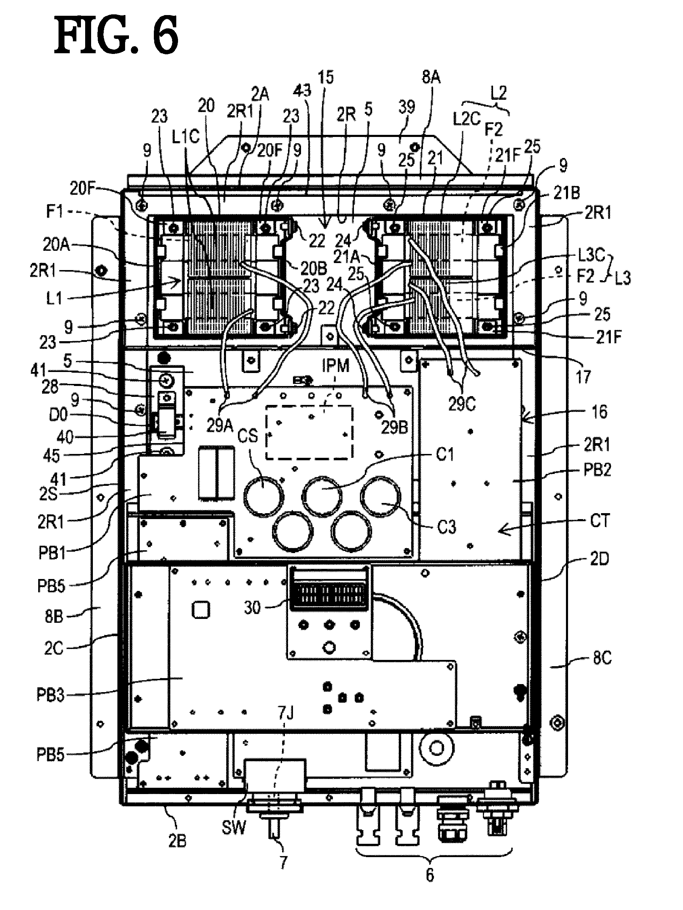

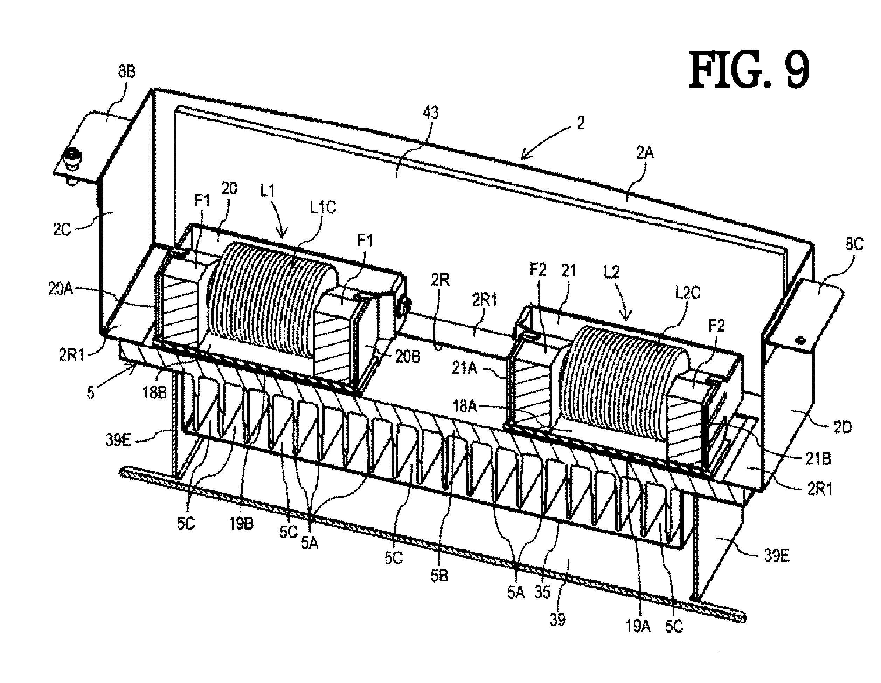

In the reactors L2, L3 as shown in FIGS. 6 and 9, coil parts L2C, L3C are wound onto two opposing sides (the top and bottom sides in FIG. 6), respectively, of a quadrilateral endless core F2, and, as shown in FIGS. 15 and 16, the external periphery of the coil parts L2C, L3C is covered by an insulating tape 26A as needed to protect the insulating coating thereof. A frame-shaped holding member 21, in which holding parts 21A, 21B for holding two opposing sides (the left and right sides in FIG. 6) of the endless core F2 on which the coil parts L2C, L3C are not wound, is attached to the endless core F2. Attachment flanges 21F formed in four locations on the holding member 21 are fixed to the base part 5B of the heat sink 5 by screws 25, and the reactors L2, L3 are thereby attached to the heat sink 5 via the thermal conducting sheet 18A and the electrically insulating sheet 19A. By this attachment, a portion of the external periphery of the coil parts L2C, L3C digs into the flexible thermal conducting sheet 18A (as indicated by the reference symbol K1), the flexible thermal conducting sheet 18A and electrically insulating sheet 19A are closely fitted, and the electrically insulating sheet 19A is closely fitted to the base part 5B of the heat sink 5, as shown in FIGS. 15 and 16. The heat generated by the reactors L2, L3 is therefore transmitted to the base part 5B of the heat sink 5 through the flexible thermal conducting sheet 18A and electrically insulating sheet 19A, and is dissipated from the heat releasing fins 5A. Screws 24 serve to fasten together a plurality of members and form the frame-shaped holding member 21.

Since heat can thus be effectively transferred from the external periphery of the reactors L2, L3 to the heat sink 5 through the thermal conducting sheet 18A when the electric circuit part of the inverter PCD is housed in a housing 1 having a sealing structure, it is possible to obtain a stably operating outdoor-mounted inverter PCD in which there is no risk of variation in the characteristics of electric circuit elements or damage to elements that arises from high temperatures in the housing 1 due to heat generated from the reactors L2, L3. A safe configuration is also obtained due to the fact that the reactors L2, L3 and the heat sink 5 can also be electrically insulated by the electrically insulating sheet 19A even when cracks or the like form in the thermal conducting sheet 18A during such processes as attaching the thermal conducting sheet 18A to the inside of the housing 1. Furthermore, the thermal conducting sheet 18A is configured from a silicone polymer material impregnated with silicone oil, and thus attains a flexible state having adhesive properties, and a technique is therefore provided whereby vibration caused by the reactors L2, L3 can be absorbed, and noise propagated to the surroundings through the sealed-structured housing 1 can be reduced.

The reactor L1 is also configured such that the external peripheral part of a coil part constituting the reactor is attached in thermally conducting fashion to the base part 5B of the heat sink 5 is exposed to the inside of the housing 1, via a flexible thermal conducting sheet 18B the same as the thermal conducting sheet 18A, and an electrically insulating sheet 19B the same as the electrically insulating sheet 19A. The thermal conducting sheet 18B is configured from a silicone polymer material impregnated with silicone oil, and the thickness thereof is substantially 3 mm to 10 mm (e.g. 5 mm). The electrically insulating sheet 19B is a synthetic resin sheet, and is a thin sheet 0.5 mm to 2 mm thick so as not to impede the conduction of heat.

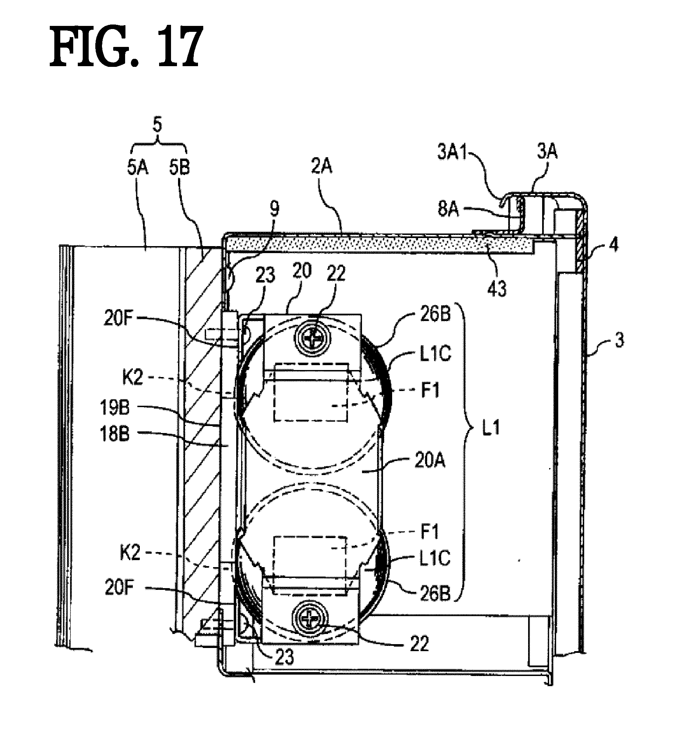

The reactor L1 is configured such that two coil parts L1C, L1C wound onto two opposing sides (the top and bottom sides in FIG. 6) of a quadrilateral endless core F1 are directly connected to form a single reactor L1, as shown in FIGS. 6 and 9. The external periphery of the coil parts L1C, L1C is covered by an insulating tape 26B as needed to protect the insulating coating thereof. In the reactor L1, a frame-shaped holding member 20, in which holding parts 20A, 20B for holding two opposing sides (the left and right sides in FIG. 6) of the endless core F1 on which the coil parts L1C are not wound, is attached to the endless core F1. Attachment flanges 20F formed in four locations on the holding member 20 are fixed to the base part 5B of the heat sink 5 by screws 23, and the reactor L1 is thereby attached to the heat sink 5 via the thermal conducting sheet 18B and the electrically insulating sheet 19B. By this attachment, a portion of the external periphery of the coil parts L1C digs into the flexible thermal conducting sheet 18B (as indicated by the reference symbol K2), the flexible thermal conducting sheet 18B and electrically insulating sheet 19B are closely fitted, and the electrically insulating sheet 19B is closely fitted to the base part 5B of the heat sink 5, as shown in FIG. 17. The heat generated by the reactor L1 is therefore transmitted to the base part 5B of the heat sink 5 through the flexible thermal conducting sheet 18B and electrically insulating sheet 19B, and is dissipated from the heat releasing fins 5A. Screws 22 serve to fasten together a plurality of members and form the frame-shaped holding member 20.

Since heat can thus be effectively transferred from the external periphery of the reactor L1 to the heat sink 5 through the thermal conducting sheet 18B when the electric circuit part of the inverter PCD is housed in a housing 1 having a sealing structure, it is possible to obtain a stably operating outdoor-mounted the inverter PCD in which there is no risk of variation in the characteristics of electric circuit elements or damage to elements that arises from high temperatures in the housing 1 due to heat generated from the reactor L1. A safe configuration is also obtained due to the fact that the reactor L1 and the heat sink 5 can also be electrically insulated by the electrically insulating sheet 19B even when cracks or the like form in the thermal conducting sheet 18B during such processes as attaching the thermal conducting sheet 18B to the inside of the housing 1. Furthermore, the thermal conducting sheet 18B is configured from a silicone polymer material impregnated with silicone oil, and thus attains a flexible state having adhesive properties, and a technique is therefore provided whereby vibration caused by the reactor L1 can be absorbed, and noise propagated to the surroundings through the sealed-structured housing 1 can be reduced.

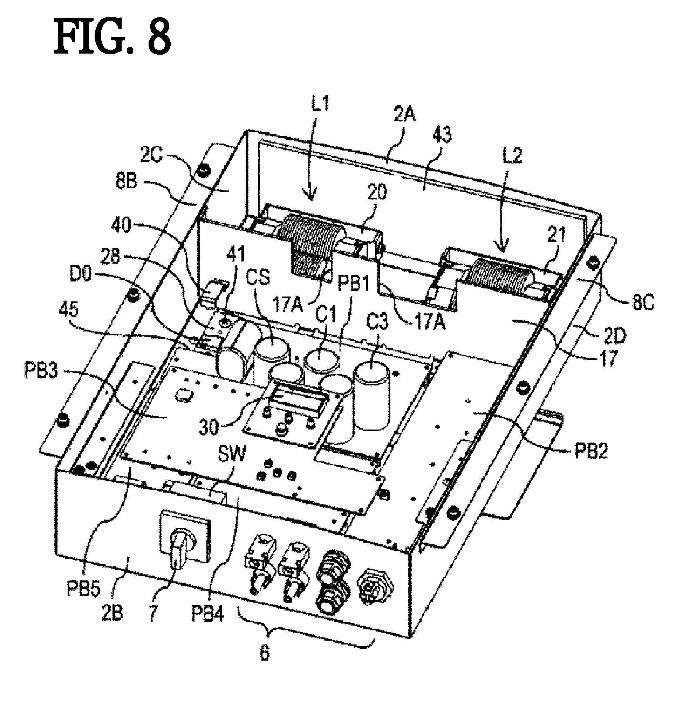

Since the reactors L1, L2, L3 generate heat, in order to ensure that this generated heat does not adversely affect other circuit elements, the inside of the housing 1 is arranged so that the first chamber 15 for housing the reactors L2, L3 provided to the filter part LPF and the reactor L1 provided to the step-up part DC/DC is in a top position, and the second chamber 16 for housing the other circuit elements is in a bottom position, as shown in FIGS. 6 and 8, and the first chamber 15 and the second chamber 16 are partitioned by the partition wall 17 for suppressing air convection between both chambers. The partition wall 17 is configured from a magnetic metal so as to prevent other circuit elements from failing due to magnetic noise and heat generated from the reactors L1, L2, L3.

When a small quantity of heat is generated by the reactor L1, a configuration may be adopted in which the reactor L1 is disposed in the second chamber 16, and attached in thermally conducting fashion to the base part 5B of the heat sink 5 exposed to the inside of the housing 1, via the flexible thermal conducting sheet 18B and electrically insulating sheet 19B the same as described above, and the reactors L2, L3 which generate large quantities of heat are disposed in the first chamber 15 according to the same configuration as described above.

As shown in FIGS. 6 and 7, terminals of the reactor L1 are wired to the printed circuit board PB1, which is one control board, by lead wires 29A, and respective terminals of the reactors L2, L3 are wired to the printed circuit board PB1 by lead wires 29B and wired to the printed circuit board PB2 by lead wires 29C, the printed circuit board PB2 being connected to the commercial power system GRID. In this case, the lead wires 29A, 29B, 29C are wired through a notch 17A in the partition wall 17.

Since this IPM is disposed in the second chamber 16, heat generated by the intelligent power module (IPM) does not adversely affect the reactors L1, L2, L3, and the heat generated from the reactors and the heat generated from the intelligent power module (IPM) is effectively released by the heat sink.

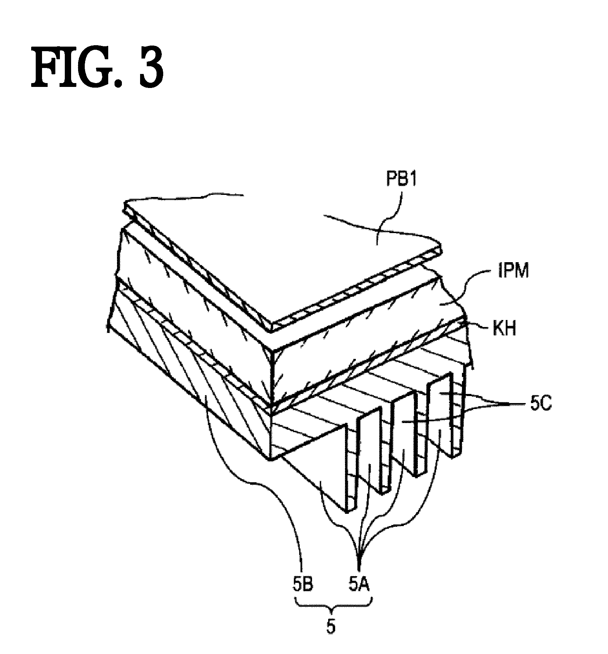

The printed circuit board PB1 is disposed parallel to the front surface side of the flat plate-shaped base part 5B of the heat sink 5, a space being provided between the printed circuit board PB1 and the base part 5B. Circuit elements that are high-voltage and generate large quantities of heat include the switching elements T2 through T5 of the DC/AC conversion circuit INV, and the intelligent power module (IPM) in which the switching elements T1 through T5 are housed in a single package, but this IPM is attached to the base part 5B of the heat sink 5 at a position not removed from the printed circuit board PB1. Specifically, the IPM is disposed on the back side of the printed circuit board PB1 in a state of being connected to the wiring of the printed circuit board PB1 as shown in FIGS. 2, 3, and 7, so as to be disposed in a space SP, and the back surface (bottom surface in FIG. 2) of the IPM is the metal heat-releasing plate KH, and this heat-releasing plate KH is fixed to the heat sink 5 by screws 12 so as to be closely fitted to the base part 5B of the heat sink 5 exposed on the housing 1 side. The heat generated from the IPM is thereby transmitted to the heat sink 5 through the heat-releasing plate KH and dissipated from the heat releasing fins 5A of the heat sink 5.

Since this IPM is disposed in the second chamber 16, heat generated by the intelligent power module (IPM) does not adversely affect the reactors L1, L2, L3, and the heat generated from the reactors and the heat generated from the intelligent power module (IPM) is effectively released by the heat sink.

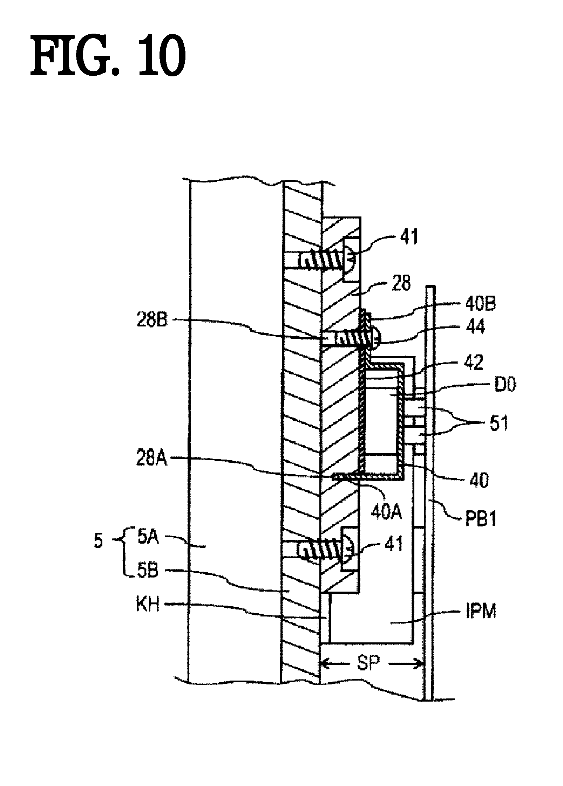

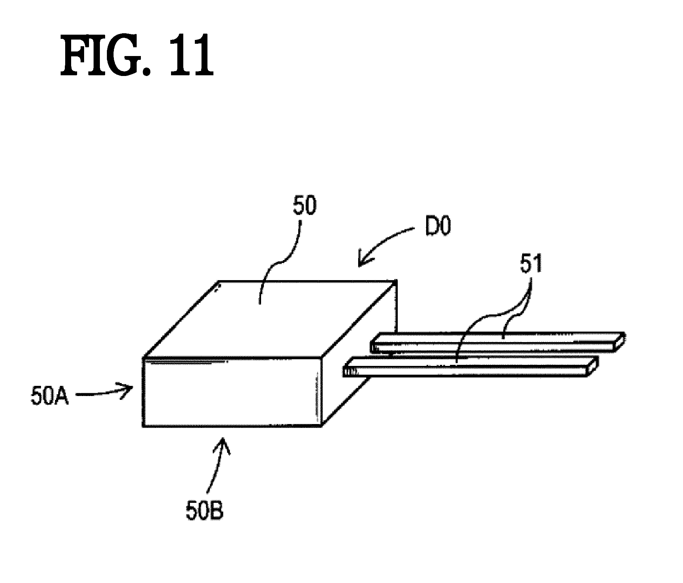

The diode DO connected to the wiring of the printed circuit board PB1 also generates heat. The step-up part DC/DC, the DC/AC conversion circuit INV, and the filter part LPF are formed on the printed circuit board PB1 and configured so that heat generated from the diode DO is transmitted to the heat sink 5 and dissipated from the heat sink 5. As shown in FIG. 11, the diode DO is packaged in a synthetic resin cover 50 having a flat cuboid shape, and has a common configuration in which two terminals 51 are extended on one side thereof. When front-side terminals 51 of the printed circuit board PB1 are connected so that the diode DO is disposed on the front side (the right side in FIG. 10) of the printed circuit board PB1, the distance between the base part 5B of the heat sink 5 and the diode DO becomes too great, and the diode DO becomes difficult to attach to the base part 5B of the heat sink 5.

Therefore, in the present embodiment, the terminals 51 are connected to the back side (the left side in FIG. 10) of the printed circuit board PB1 so that the diode DO is positioned near the base part 5B of the heat sink 5. In an arrangement such as this, when the terminals 51 of the diode DO are connected to the back side (the left side in FIG. 10) of the printed circuit board PB1 in a linear state such as shown in FIG. 11, problems arise in that a large space is necessary between the back side of the printed circuit board PB1 and the base part 5B of the heat sink 5, the thickness of the housing 1 is increased, the surface of the diode DO that contacts the base part 5B of the heat sink 5 is the surface (surface 50A in FIG. 11) on the opposite side from the terminals 51, the heat-releasing surface area of the diode DO is too small, and heat is no longer adequately released.

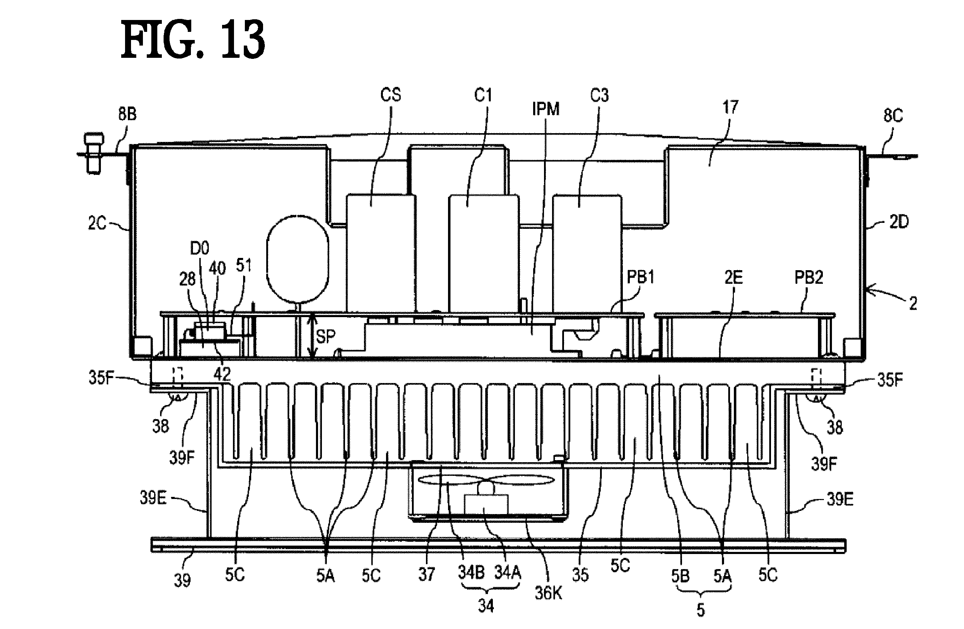

In view of such problems, the present embodiment provides a configuration in which the housing 1 has a small thickness, and the heat of the diode DO can be satisfactorily released. A configuration is therefore adopted in which a thermally conducting attachment is made via a thermal conducting block 28 (thermal conduction member) to the base part 5B of the heat sink 5 at a position removed from the printed circuit board PB1 and near the external periphery of the printed circuit board PB1. Specifically, as shown in FIGS. 10 and 13, a configuration is adopted in which distal end parts of the terminals 51 of the diode DO are bent at a substantially right angle so that the terminals 51 are parallel to the printed circuit board PB1, the terminals 51 are connected to the back side (space SP side) of the printed circuit board PB1, and the diode DO is disposed at a position removed from the printed circuit board PB1 and attached to the base part 5B of the heat sink 5 at this position. Specifically, the diode DO is arranged so as to correspond to a notch 45 formed in an end part of the printed circuit board PB1. The diode DO is fixed by a thermally conductive fastener 40 to the thermal conducting block 28 so that a face (bottom surface 50B in FIG. 11) of the flat cuboid that has a large surface area faces the aluminum thermal conducting block 28 attached by screws 41 to the base part 5B of the heat sink 5. In a state in which the fastener 40 covers the diode DO so that a retaining protrusion 40A at one end of the fastener 40 is retained in a retaining hole 28A formed in the thermal conducting block 28, an attachment flange 40B at the other end of the fastener 40 is fixed by a screw 44 that screws into a screw hole 28B formed in the thermal conducting block 28.

In this case, a synthetic resin electrically insulating sheet 42 having a thickness of 0.5 mm to 2 mm is interposed between the diode DO and the thermal conducting block 28 to maintain electrical insulation between the diode DO and the heat sink 5. Since the electrically insulating sheet 42 is thin, the heat generated by the diode DO is transferred to and dissipated by the base part 5B of the heat sink 5 via the thermal conducting block 28.

Since the terminal 5 of an existing diode DO are commonly of predetermined length, when the terminals 51 are not bent at a substantially right angle so as to be parallel to the printed circuit board PB1 as described above, the diode DO cannot be disposed further to the outside than the end part of the printed circuit board PB1. Using a diode DO that has a particularly long terminal 51 length is not preferred, because of a resultant increase in cost of the diode D0. Therefore, in order to obtain effective release of heat in the present embodiment even when an existing diode DO is used, a notch 45 is formed in the end part of the printed circuit board PB 1, the diode DO is arranged to correspond to the notch 45, and the thermal conducting block 28 is attached so as to fill the space that occurs between the diode DO and the base part 5B of the heat sink 5.

By the attachment of the diode DO in this manner, the diode DO is positioned in an extension of the space SP between the printed circuit board PB1 and the heat sink 5. As described above, the IPM is attached to the back side of the printed circuit board PB1 in a state of connection to the wiring of the printed circuit board PB1, and is disposed in the space SP. The heat-releasing plate KH on the back surface of the IPM is attached so as to be closely fitted to the base part 5B of the heat sink 5. The space SP is therefore necessary for attaching at least the IPM.

By this configuration in which the diode DO is attached on the same side of the printed circuit board PB1 as the IPM, attachment to the base part 5B of the heat sink 5 is facilitated. Since the diode DO is also positioned in an extension of the space SP, the diode DO is located in a passage for air that ascends through the space SP, and is also cooled by this ascending air, and excellent release of heat is obtained.

By a diode DO attachment configuration such as described above, the heat from the diode DO is also satisfactorily released to the base part 5B of the heat sink 5 via the thermal conducting block 28, while at the same time, the distance from the portion of the base part 5B of the heat sink 5 through which the heat of the reactor L1 is transferred increases commensurately with the thickness of the thermal conducting block 28, and the diode DO is not prone to interference by heat release from the reactor L1. Therefore, the diode DO can be disposed at the top of the second chamber 16 in the vicinity of the reactor L1 and adjacent to the partition wall 17, and the lead wires 29A for connecting the reactor L1 to the printed circuit board PB1, and the lead wires 29B for connecting the reactor L2 to the printed circuit board PB1 can be made correspondingly shorter, as shown in FIG. 6. This configuration also makes it possible to use a small housing 1.

Since the heat sink 5 has a monolithic configuration, and the heat-generating electrical components including the diode D0, the switching elements T2 through T5 constituting the DC/AC conversion circuit INV, and the reactors L1 through L3 are attached to the base part 5B of the heat sink 5 as described above, the configuration of the heat-releasing housing 1 can be simplified relative to a case in which a heat sink for heat release is provided to each of the electric components above, and the placement and attachment of these electric components are facilitated.

In the housing 1, a heat release promoting fan 34 is provided on the back side of the heat sink 5, and the heat release promoting fan 34 is disposed in a position substantially corresponding to that of the intelligent power module (IPM). When a heat release promoting fan 34 is not provided, release of heat by the heat sink 5 depends solely on the natural flow of air that ascends between the heat releasing fins 5A of the heat sink 5, the portion of the heat sink 5 through which the heat of the intelligent power module (IPM) is transmitted attains a high temperature, and the heat of this portion is transferred through the heat sink 5, thereby hindering reduction of the temperature of the portion of the heat sink 5 through which the heat generated from the reactors L1, L2, L3 is conducted, and reducing the release of heat generated from the reactors L1, L2, L3. However, providing the heat release promoting fan 34 prevents such problems and makes it possible to enhance both the release of heat from the intelligent power module (IPM) and the release of heat generated from the reactors L1, L2, L3.

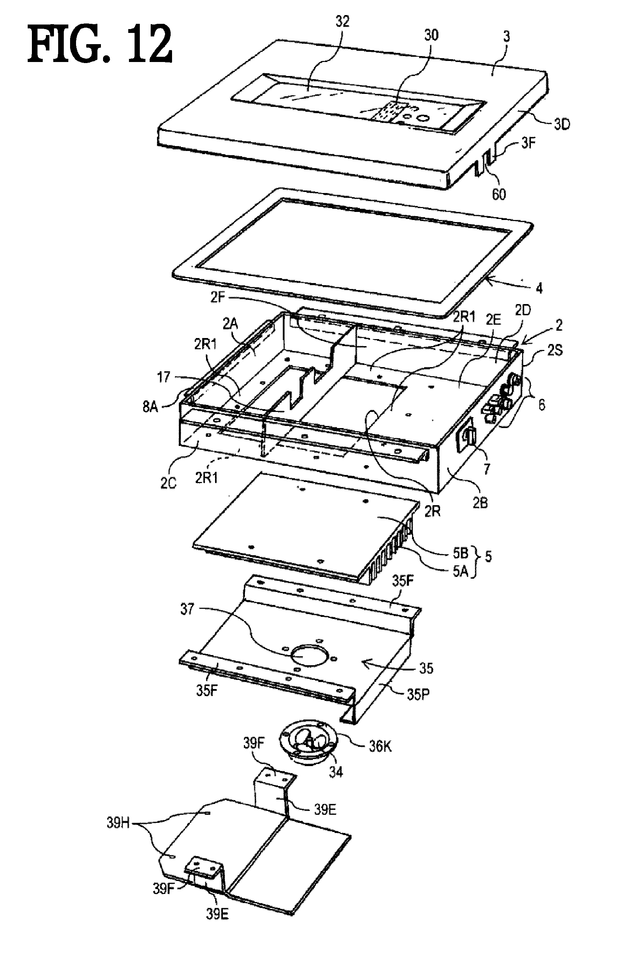

The heat release promoting fan 34 of the present embodiment is configured as a propeller 34B that is caused to rotate by an electric motor 34A attached to a fan case 36K, as shown in FIG. 13, but a fan of a different configuration may also be used. As shown in FIGS. 7, 9, 12, and 13, a cover plate 35 is provided having a surface area that covers the entire back side of the heat releasing fins 5A of the heat sink 5, a ventilation hole 37 is formed in a center part of the cover plate 35, and the fan case 36K is attached by a screw to the rim of the ventilation hole 37 so that the heat release promoting fan 34 attached to the fan case 36K faces the ventilation hole 37.

Left and right flange parts 35F of the cover plate 35 to which the heat release promoting fan 34 is attached are fixed by screws 38 to left and right portions of the base part 5B of the heat sink 5. The heat release promoting fan 34 thereby faces the air passages between the heat releasing fins 5A of the heat sink 5, in a state in which the cover plate 35 covers the entire back side of the heat releasing fins 5A of the heat sink 5, as shown in FIG. 13, and is positioned on the back side substantially corresponding to the intelligent power module (IPM). As shown in FIG. 7, the heat release promoting fan 34 is positioned somewhat towards the top of the intelligent power module (IPM) in the present embodiment, but the heat release promoting fan 34 is preferably positioned directly behind the intelligent power module (IPM).

In order for the inverter PCD to be attached substantially vertically along an outer upright wall or the like of a dwelling as shown in FIG. 7, an attachment plate 39 covering the heat release promoting fan 34 is disposed on the upper half of the back side of the cover plate 35 to which the heat release promoting fan 34 is attached, and distal-end flange parts 39F of attachment legs 39E formed on both the left and right sides of the attachment plate 39 are fixed by screws to left and right portions of the base part 5B of the heat sink 5, as shown in FIGS. 7, 9, 12, and 13. The screws may be dedicated screws, or the screws 38 for attaching the cover plate 35 may be used jointly. Attachment holes 39H for attachment to the outer upright wall or the like of a dwelling are formed in a top part of the attachment plate 39. A space maintaining part 35P formed by bending to the rear is formed at a bottom end part of the cover plate 35, and a rearward distal end 35P1 of the space maintaining part 35P is formed so as to be on a downward extension of the attachment plate 39. Since the rearward distal end 35P1 of the space maintaining part 35P thereby comes in contact with the outer upright wall or the like of the dwelling when the attachment plate 39 is attached to the outer upright wall or the like of the dwelling, it is possible to maintain a substantially vertical attachment of the inverter PCD to the outer upright wall or the like of the dwelling.

A flat plate-shaped heat insulator 43 having a predetermined thickness is bonded to an inside surface of the top wall 2A of the casing 2, i.e., an inside surface of the top wall 2A of the first chamber 15 in which the reactors L1, L2, L3 are housed. When the heat insulator 43 is not present, since the top wall 2A of the first chamber 15 is heated by the heat generated by the reactors L1, L2, L3, condensation forms on the top wall 2A of the first chamber 15 when the temperature around the inverter PCD decreases, and there is concern that the condensation may fall onto the reactors L1, L2, L3 or into the second chamber and adversely affect electrical insulation. However, providing the heat insulator 43 prevents this condensation, and therefore eliminates the concern.

A display 30 is attached to the printed circuit board PB3, the display 30 faces a window 33 formed in a portion of a longitudinally directed depression 31 formed in the center part of the lid 3, and a transparent resin cover 32 is bonded in a watertight state in the entire depression 31 to prevent raindrops from penetrating into the housing 1 from the window 33. The display 30 displays the operational state of the inverter PCD, error codes during failure, and the like.

### INDUSTRIAL APPLICABILITY

The inverter according to the present invention is not limited to the configuration described in the embodiment above, is applicable to various configurations, and encompasses various forms within the technical scope of the present invention.

### [Key to Symbols]

- 1: housing
- 2: metal casing
- 2S: peripheral wall of casing 2
- 3: metal lid
- 3A: top edge of lid 3
- 3A1: retaining part of top edge 3A of lid 3
- 3B, 3C: attachment parts formed at left and right edges of lid 3
- 3F: flange
- 4: waterproofing gasket
- 5: heat sink
- 5A: heat releasing fins
- 5B: base part
- 5C: air passages
- 6: lead wire lead-outs
- 7: switch operating part for manual operation
- 7J: shaft
- 8A: retaining flange
- 8B, 8C: attachment flanges
- 9: screws
- 11: screws
- 12: screws
- 15: first chamber
- 16: second chamber
- 17: partition wall
- 18A, 18B: thermal conducting sheet
- 19A, 19B: electrically insulating sheet
- 20, 21: holding member
- 26A, 26B: insulating tape
- 28: thermal conducting block
- 29A, 29B, 29C: lead wires
- 30: display
- 34: heat release promoting fan
- 35: cover plate
- 37: ventilation hole
- 39: attachment plate
- 40: fastener
- 41: screws
- 44: screw
- 51: diode terminals
- 60: hole or notch
- 61: rotating retaining part
- 62: fixed-side retaining part
- PCD: inverter
- MC: main circuit of an inverter PCD
- IPM: intelligent power module
- DC/DC: step-up part
- L1: reactor of step-up part DC/DC
- D1: diode
- DO: diode
- INV: DC/AC conversion circuit
- LPF: filter part
- L2, L3: reactors of filter part LPF
- GRID: commercial power system
- PV: solar cell
- PB1, PB2, PB3, PB4: printed circuit boards

## Claims

1. An inverter in which a step-up part for boosting the voltage of a direct-current power generated by a solar cell or the like, a DC/AC conversion circuit for converting the direct-current power boosted by said step-up part into alternating-current power, and a filter part for shaping the waveform of the alternating-current power converted by said DC/AC conversion circuit are housed in a single housing; wherein
said inverter is **characterized in that**: said housing has a sealing structure for water; at least a portion of a back panel of the housing comprises a heat sink; a printed circuit board is disposed substantially parallel to a base part of said heat sink, a space being present between the printed circuit board and the heat sink; a heat-generating electrical part constituting said step-up part is connected to said printed circuit board and attached in thermally conducting fashion to the base part of said heat sink via a thermal conducting member at a position removed from said printed circuit board and near an external periphery thereof; and a switching element constituting said DC/AC conversion circuit is connected to said printed circuit board and attached in thermally conducting fashion to the base part of said heat sink at a position not removed from said printed circuit board.

2. The inverter according to claim 1, **characterized in that** inside said housing, a reactor constituting said filter part is housed in a top-part side, other circuit elements including said printed circuit board are housed in a underside, and a passage for ascension of air is configured in said space between said printed circuit board and the base part of said heat sink.

3. The inverter according to claim 1 or 2, **characterized in that** said heat sink is made of aluminum, said thermal conducting member is made of aluminum as a block shape attached to the base part of said heat sink, and said heat-generating electrical part is fixed to a top-surface side of said heat conducting member using a fastener.

4. The inverter according to claim 1, **characterized in that** the external periphery of a coil of the reactor provided to said filter part is attached in thermally conducting fashion to the base part of said heat sink via a flexible thermal conducting sheet and electrically insulating sheet.

5. The inverter according to claim 4, **characterized in that** the external periphery of the reactor provided to said step-up part is attached in thermally conducting fashion to the base part of said heat sink via a flexible thermal conducting sheet and electrically insulating sheet.

6. The inverter according to claim 5, **characterized in that** the inside of said housing is partitioned by a partition wall so that a chamber housing a reactor provided to said filter part and a reactor provided to said step-up part is an upper chamber, and a chamber housing other circuit elements including said printed circuit board is a lower chamber, the partition wall suppressing air convection between both said chambers, and said heat-generating electrical component is disposed adjacent to said partition wall and in the vicinity of said reactors.

7. The inverter according to claim 3, **characterized in that** the inside of said housing is partitioned by a partition wall so that a chamber housing said reactors is an upper chamber, and a chamber housing other circuit elements including said printed circuit board is a lower chamber, the partition wall suppressing air convection between both said chambers, and said heat-generating electrical part is disposed adjacent to said partition wall and in the vicinity of said reactors.

8. The inverter according to claim 6, **characterized in that** said thermal conducting sheet is flexible and has a thickness such that an external periphery of a coil of said reactor makes contact with the thermal conducting sheet so as to dig into a surface thereof, and said electrically insulating sheet holds a back surface of said thermal conducting sheet and has a thickness such that heat generated by said reactors is satisfactorily transmitted to said heat sink.

9. The inverter according to claim 8, **characterized in that** said housing is sealed up from water , in which an opening on a front side of a casing, which is open on said front side thereof, a periphery of which being enclosed by metal plates, and at least a portion of a back panel thereof comprising a heat sink, is closed by an openable and closable lid, said heat sink side is an attachment side in a state in which said opening is on the front side and a chamber housing said reactors is in a top position, an intelligent power module (IPM) in which a plurality of switching elements are electrically connected in a bridge shape so as to constitute said DC/AC conversion circuit is disposed in the chamber housing said other circuit elements, and a heat-releasing surface of said intelligent power module (IPM) is attached in thermal conducting fashion to said heat sink exposed to the inside of said housing.

10. The inverter according to claim 9, **characterized in that** in said housing, a cooling fan is provided on the back side of said heat sink, and said cooling fan is disposed in a position corresponding to that of said intelligent power module (IPM).

11. The inverter according to claim 1, **characterized in that**: said housing is provided with a casing opened on a front side thereof and having said back panel, a lid detachably fixed to said casing so as to open and close the front side opening of the casing, and a gasket attached to a back side of said lid and closely fitted in a state where a front end of a peripheral wall of the front side opening of said casing digs into the gasket; a switch for opening and closing a predetermined circuit part of said inverter is provided inside said casing; a switch operating part for manual operation of said switch is provided in a downward protruding state in a bottom wall of the peripheral wall of said casing; and a lid opening/closing restricting part is provided whereby removal of said lid from said casing is inhibited when said switch operating part is in an ON state of closing a switch circuit, and said inhibiting is removed when said switch operating part is in an OFF state of opening the switch circuit.

12. The inverter according to claim 11, **characterized in that** said switch operating part is a rotary-type switch operating part which rotates from the OFF state of opening the switch circuit to the ON state of closing the switch circuit, and returns from the ON state of the switch to the OFF state of the switch by rotating in the opposite direction from the rotation, and said lid opening/closing restricting part is provided with a structure in which a fixed-side retaining part, on which a rotating retaining part is retained or released, is provided on a back side of said lid, the rotating retaining part rotating in conjunction with rotation of said switch operating part, and said rotating retaining part is retained on said fixed-side retaining part and removal of said lid is inhibited when said switch is ON, and said inhibition is removed when said switch is OFF.
